# FASCICULE DE BREVET EUROPEEN

(11) **EP 2 681 771 B1**
(45) Date de publication et mention de la délivrance du brevet: **23.09.2015**
(21) Numéro de dépôt: 12708961.3
(22) Date de dépôt: 01.03.2012
(51) Int. Cl.: H01L 27/142, H01L 31/18, H01L 31/032

(54) **PROCEDE DE GRAVURE CHIMIQUE SELECTIVE**
SELEKTIVES CHEMISCHES ÄTZVERFAHREN
SELECTIVE CHEMICAL ETCHING PROCESS

(30) Priorité: 02.03.2011 FR 1100624
(43) Date de publication de la demande: 08.01.2014
(73) Titulaire: Commissariat à l'Énergie Atomique et aux Énergies Alternatives, 75015 Paris (FR)
(72) Inventeur: RAPISARDA, Dario, F-38190 Villard Bonnot (FR); DUFOURCQ, Joël, F-64270 Puyoo (FR); PERRAUD, Simon, F-83150 Bandol (FR); PONCELET, Olivier, F-38000 Grenoble (FR)
(74) Mandataire: Majidi, Assieh
(86) Numéro de dépôt international: PCT/IB2012/050975
(87) Numéro de publication internationale: WO 2012/117372

(56) Documents cités:
- WO-A1-2010/058283
- CANAVA B. ET AL: "Increasing solar cell efficiencies based on Cu(In,Ga)Se2 after a specific chemical and oxidant treatment", PHYS. STAT. SOL. (C), vol. 3, no. 8, 4 septembre 2006 (2006-09-04), pages 2551-2554, XP002668171, Weinheim DOI: 10.1002/pssc.200669614
- BOUTTEMY M. ET AL: "Thinning of CIGS solar cells: Part I: Chemical processing in acidic bromine solutions", THIN SOLID FILMS, no. 519, 15 janvier 2011 (2011-01-15), pages 7207-7211, XP002668172, DOI: 10.1016/j.tsf.2010.12.219

## Description

Toute référence au terme "invention" doit seulement être comprise comme exemple d'application des préceptes décrits dans la description, à moins que « l'invention » soit explicitement revendiquée.

La présente invention se rapporte à un procédé de gravure chimique sélective, par voie humide, d'un substrat en couches minces comprenant une couche de surface en CIGS.

La présente invention se rapporte également à un procédé de réalisation de cellules en série dans des modules photovoltaïques en couches minces, mettant en oeuvre le procédé de gravure chimique sélective par voie humide selon l'invention.

La présente invention se rapporte, en outre, à un procédé pour créer des motifs de dimensions réduites, comme par exemple des interconnexions monolithiques, sur des dispositifs photovoltaïques en couches minces, mettant en oeuvre le procédé de gravure chimique sélective par voie humide selon l'invention.

Le domaine de la conversion photovoltaïque de l'énergie solaire connaît depuis quelques années un développement spectaculaire. Les matériaux en couches minces comprenant une couche de 1 à 5 µm en alliage Cu-In-Ga-S ou Cu-In-Ga-Se (CIGS), sont des matériaux particulièrement efficaces pour effectuer la conversion photovoltaïque et, par conséquent, être utilisés dans la fabrication de panneaux photovoltaïques en couches minces. Afin de pouvoir moduler le rendement de conversion électrique et fournir la différence de potentiel prévue par les cahiers des charges, le module photovoltaïque doit être muni d'un nombre adapté de cellules en série.

Un procédé fréquemment utilisé pour la formation de cellules à la surface d'un module photovoltaïque en couches minces est la gravure mécanique (W. N. Shafarman et L. Stolt, Handbook of Photovoltaic Science and Engineering, Chapitre 13, pages 604-605) qui consiste à creuser, avec des fraises de tailles et de géométries variables, des sillons selon un parcours déterminé. Ce type de procédé présente des inconvénients. En effet, la gravure mécanique n'est pas sélective : la gravure peut attaquer indifféremment les différentes couches constitutives du module et/ou endommager la surface dudit module, réduisant ainsi ses caractéristiques électriques. Outre la surface à graver, la gravure mécanique peut occasionner des pertes de surface utile au niveau de la couche de CIGS. De plus, le taux de gravure par ce type de procédé n'est pas toujours suffisant, ce qui allonge le procédé de gravure, et donc augmente les chances de détruire les autres couches et/ou d'endommager la surface du module.

Une autre technique utilisée pour la formation de cellules à la surface d'un module photovoltaïque en couches minces est la gravure chimique, par voie humide, qui consiste à plonger le substrat dans une solution qui va attaquer chimiquement la surface à graver. Cette technique présente plusieurs avantages. Elle est relativement facile à mettre en oeuvre et donc intéressante d'un point de vue industriel. Le taux de gravure par cette technique est particulièrement élevé, ce qui rend la gravure rapide.

Ainsi :
- R.W. Birkmire and B.E. McCandless, (Appl. Phys. Lett.,1988, 53(2), pages 140-141) ont décrit un procédé de gravure chimique dans le but d'obtenir des surfaces de CIS spéculaires. Cette qualité de la surface du CIS est recherchée afin d'améliorer les caractéristiques électriques des cellules tandem α-Si : CuInSe₂. La solution de gravure est une solution aqueuse de brome (Br₂) avec des concentrations allant de 0,02 mol/l à 0,25 mol/l. Les vitesses d'attaque observées (après des gravures à température ambiante) allaient de 0,1 à 5,5 µm/min.
- Canava et al. (Journal of Physics and Chemistry of Solids, 2003, 64, pages 1791-1796) ont également décrit un procédé de gravure chimique, par voie humide, dans le but d'obtenir des surfaces en CIGS spéculaires et de contrôler la composition des films minces, notamment la composition de la couche de CIGS. Dans ce procédé, un substrat en verre comprenant une couche de molybdène et une couche de CIGS partiellement protégée par une résine, est plongé dans une solution 0,001-1 mol/l de Br₂ dans l'eau, à température ambiante et pendant quelques secondes, puis traité par une solution de 0,1 mol/l de KCN à 70°C. L'analyse de la couche de CIGS montre une diminution de l'épaisseur de cette couche après gravure, et une variation de la composition de la couche de CIGS (couche plus ou moins riche en Se).

Le but dans ces documents n'est pas d'enlever, par endroits, toute la couche de CIGS mais d'obtenir des surfaces en CIGS spéculaires, c'est-à-dire ayant un poli miroir. Rampino et al. (WO 2010/058283) ont décrit un procédé gravure chimique, par voie humide, comprenant la gravure d'une couche CIGS utilisant une solution de Br2 dans l'eau.

Les inconvénients majeurs de ces procédés de gravure chimique sont :
- un dégagement important de vapeurs toxiques de Br₂, et/ou
- la non sélectivité de la gravure de la couche de CIGS par rapport à la couche de molybdène.

La demande de brevet US 2007/0227578 décrit un procédé de gravure chimique d'un module photovoltaïque en couches minces comprenant une couche de surface en CIGS, dans lequel la gravure de la couche en CIGS se fait sélectivement par rapport à la couche de résine photosensible et à la couche métallique sous-jacente. La solution de gravure utilisée est un mélange de H₂SO₄ et de H₂O₂. L'un des inconvénients de cette méthode est l'utilisation du mélange H₂SO₄ et de H₂O₂, qui est un mélange réactif et dangereux, et donc difficilement utilisable dans l'industrie. Par ailleurs, malgré les affirmations des auteurs, l'expérience montre que le procédé de gravure chimique de la couche en CIGS dans US 2007/0227578, n'est pas sélectif. En effet, si toute la couche de CIGS est gravée conformément au procédé décrit dans US 2007/0227578, la couche métallique sous-jacente le sera également. Canava et al. (Phys. Stat. Sol. (C), vol. 3, no.8, 2006) décrit un procédé de gravure chimique par voie humide d'un substrat en couches minces comprenant au moins une couche de surface en CIGS à graver, et une couche métallique sous-jacente comprenant de Mo déposée sur un substrat.

Il existe donc un réel besoin d'un procédé de gravure sélective, en particulier de gravure chimique sélective, par voie humide, d'un substrat en couches minces comprenant une couche de surface en CIGS, palliant les inconvénients de l'art antérieur.

En particulier, il existe un réel besoin d'un procédé de gravure chimique sélective, par voie humide, qui permette de graver la couche de surface en CIGS d'un substrat en couches minces qui comprend également une couche métallique sous-jacente comprenant du molybdène, sans que ladite couche métallique sous-jacente ne soit attaquée.

Plus particulièrement, il existe un réel besoin d'un procédé de gravure chimique sélective par voie humide qui évite de recourir à des réactifs chimiques toxiques, polluants et/ou dangereux et qui évite les pertes de surface utiles au niveau de la couche de CIGS.

La présente invention a précisément pour but de répondre à ces besoins en fournissant un procédé de gravure chimique sélective par voie humide d'un substrat en couches minces comprenant au moins une couche de surface en CIGS à graver, et une couche métallique sous-jacente comprenant du molybdène déposée sur un support, caractérisé en ce qu'il comprend les étapes suivantes :
a) immerger le substrat à graver dans une solution comprenant :
   - au moins un précurseur de Br₂ ou de Cl₂,
   - au moins un monoacide organique, et
   - au moins un composé de formule MX dans laquelle
      - M représente un métal alcalin choisi parmi le sodium, le potassium ;
      - X représente un atome d'halogène choisi parmi le chlore, le brome ;
b) soumettre le substrat immergé dans la solution mise en oeuvre à l'étape a), à un traitement thermique permettant la réaction sélective de Br₂ ou de Cl₂ avec la couche de surface précitée.

Les molécules de Br₂ ou de Cl₂ sont aptes à réagir avec la couche de surface en CIGS et à ne pas réagir avec la couche métallique sous-jacente comprenant du molybdène.

Ainsi, le procédé de l'invention présente l'avantage de graver la couche de surface en CIGS, de manière précise et contrôlée, en réduisant le plus possible les pertes de surface utile au niveau de cette couche.

Il permet également de contrôler avec une grande précision la qualité de la couche superficielle et son état de surface final après gravure.

Dans le cadre de la présente invention, par solution, on entend un mélange homogène ou hétérogène de deux ou de plusieurs composés dans un solvant ou un mélange de solvants. Le terme « solution » englobe ainsi les solutions, les solutions saturées, les suspensions et/ou les dispersions. De préférence, la solution est un mélange homogène de deux ou de plusieurs composés dans un solvant ou un mélange de solvants.

Au sens de l'invention, par gravure, on entend l'opération qui consiste à enlever, partout où elle n'est pas désirée, la totalité de la couche de surface en CIGS, dans un substrat en couches minces comprenant, outre ladite couche de surface en CIGS, une couche métallique sous-jacente comprenant du molybdène, laquelle couche métallique est déposée sur un support.

Dans le cadre de l'invention, le substrat en couches minces est un substrat qui comprend un support revêtu d'une première couche métallique comprenant du molybdène, elle-même revêtue d'une couche de CIGS. Ledit substrat en couches minces peut être, par exemple, un module d'un dispositif photovoltaïque.

Le terme CIGS est utilisé au sens large et signifie un alliage de cuivre, d'indium, de gallium et de sélénium ou de soufre répondant à la formule chimique CuIn_{y}Ga_{(1-y)}Q₂, dans laquelle la valeur de y peut varier de 1 à 0 et Q peut être un atome de soufre ou de sélénium. Des variantes de CIGS dans lesquelles le gallium est absent et/ou le sélénium est remplacé par du soufre sont également couvertes par ce terme. Tous les matériaux en CIGS de l'état de la technique peuvent convenir à la présente invention. A ce titre, on peut citer, par exemple, les matériaux en CIGS décrits dans Y. Hamakawa, « Thin-Film Solar Cells », chapitre 10 (2004).

Dans l'invention, l'épaisseur de la couche de CIGS, avant gravure, est typiquement comprise entre 1 et 5 µm, bornes incluses.

Comme déjà indiqué, dans l'invention, la gravure de la couche de CIGS par le procédé de l'invention conduit à une élimination totale de la couche de CIGS dans les zones voulues.

Ainsi, avec le procédé de l'invention, typiquement, les zones de CIGS éliminées ont une taille (plus grande dimension entre hauteur et largeur) de l'ordre de l'épaisseur de la couche de CIGS au départ.

Le support peut être choisi parmi le verre, l'acier inoxydable et le plastique comme le Kapton^{®}, les aramides résistants à 400°C, les fibres Kermel^{®} résistants à 1000°C. Le support est plus particulièrement du verre, et encore plus particulièrement, du verre sodo-calcique.

Selon un mode de réalisation avantageux du procédé de l'invention, la solution mise en oeuvre à l'étape a) comprend :
- au moins un précurseur de Br₂ ou de Cl₂ de formule (I) :

   MXOₓ (I)

   dans laquelle M et X ont les mêmes définitions que pour le composé MX, et x est un nombre entier compris entre 1 et 3, bornes incluses ; et
- au moins un solvant polaire.

Comme indiqué, outre le précurseur de Br₂ et de Cl₂ et le solvant polaire, la solution de gravure mise en oeuvre à l'étape a) comprend, au moins un monoacide organique.

La solution de l'invention permet de générer *in situ,* du Br₂ ou du Cl₂ selon la réaction suivante :

MOX₃ + monoacide organique →XO₃⁻ + 5X⁻ + 6H⁺ → 3X₂ + 3H₂O

avec passage par l'intermédiaire MXO et éventuellement MXO₂.

Ainsi, le précurseur de Br₂ ou de Cl₂ peut aussi bien avoir la formule MOX₃, que la formule MXO, que la formule MXO₂, lorsque ces dernières existent de façon stable dans le solvant polaire, en particulier dans l'eau.

Cette génération *in situ,* du Br₂ ou du Cl₂ limite le dégagement de Br₂ et de Cl₂, par rapport au cas où l'on utilise une solution contenant du Br₂ ou du Cl₂ déjà formé.

Par monoacide organique, on entend un composé de formule RCOOH dans lequel R peut être un groupe alkyle en C₁ à C₁₂, ou un groupe aryle en C₆ à C₂₀.

On entend par « alkyle », au sens de la présente invention, un radical carboné linéaire, ramifié ou cyclique, saturé ou insaturé, éventuellement substitué, comprenant 1 à 12 atomes de carbone. A titre indicatif, on peut citer les radicaux méthyle, éthyle, propyle, butyle, isobutyle, pentyle, hexyle, octyle, nonyle, décyle, undécyle, dodécanyle et leurs isomères ramifiés. Comme alkyle cylique, on peut également citer les radicaux cyclopropyle, cyclobutyle, cyclopentyle, cyclohexyle, bicylco[2,1,1] hexyle, bicylco[2,2,1] heptyle. Le groupe alkyle peut être éventuellement substitué par un ou plusieurs groupes hydroxyle, par un ou plusieurs atomes d'halogène choisi parmi le fluor, le chlore, le brome, l'iode.

Le terme « aryle » désigne de manière générale un substituant aromatique cyclique comportant de 6 à 20 atomes de carbone. Dans le cadre de l'invention le groupe aryle peut être mono- ou poly- cyclique. A titre indicatif, on peut citer le phényle, le naphtyle. Le groupe aryle peut être éventuellement substitué par un ou plusieurs groupes hydroxyle, par un ou plusieurs atomes d'halogène choisi parmi le fluor, le chlore, le brome, l'iode.

Le choix du ou des monoacide(s) organique(s) dans l'étape a) est important, voire déterminant. Ainsi, par son acidité (pKa), le monoacide organique doit être capable de réagir avec le précurseur de Br₂ ou de Cl₂, afin de libérer du Br₂ ou du Cl₂ qui attaquera la couche de surface en CIGS du substrat en couches minces. Par sa forme dans l'espace ou son encombrement stérique, le monoacide organique doit empêcher le Br₂ ou le Cl₂, d'accéder à la couche métallique ou tout au moins ralentir son approche de ladite couche métallique.

Il est donc important que le monoacide organique soit :
- suffisamment fort (pKa) pour assurer la génération de Br₂ ou de Cl₂, à partir de son précurseur ;
- suffisamment encombré, c'est-à-dire ayant une masse moléculaire d'au moins 60 g/mol, pour lui permettre de passiver et protéger la couche sous-jacente comprenant du molybdène ou entièrement constitué du molybdène. Sans vouloir être lié par la théorie, en effet, lorsqu'un acide organique réagit avec une couche de métal oxophile comme le molybdène, il forme immédiatement un carboxylate. Ce carboxylate est en équilibre avec la forme libre de l'acide dans la solution. Si l'acide est « petit », cet échange est très rapide et le métal pourra être attaqué. En revanche, si la l'acide est suffisamment « encombrant », cet échange est très ralenti et le métal est ainsi protégé ;
- suffisamment soluble, c'est-à-dire une solubilité d'au moins 20g/l, pour empêcher la formation d'une émulsion lorsque les monoacides ont des masses moléculaires élevées, typiquement de l'ordre de 200 g/mole.

De préférence, les monoacides organiques satisfont aux conditions suivantes :
- un pKa inférieur à 5, en particulier 0,5 ≤ pKa < 5, plus particulièrement 0,7 ≤ pKa ≤ 4,9 ;
- une masse moléculaire (MW) d'au moins 60 g/mole, en particulier 60 g/mole ≤ masse moléculaire (MW) ≤ 200 g/mole, plus particulièrement 70 g/mole ≤ MW ≤ 125 g/mole ;
- une solubilité d'au moins 20 g/l, en particulier 20 g/l ≤ solubilité < 1000 g/l.

Dans le cadre de la présente invention, par solubilité d'un composé, on entend la quantité maximale (en grammes par litre) de ce composé que l'on peut dissoudre ou dissocier dans 1 litre d'eau à 20°C.

Le pKa définit la force d'un acide. Les valeurs de pKa indiquées ci-dessus ont été déterminées à 20°C.

Les monoacides organiques selon l'invention sont de préférence choisis parmi l'acide acétique ; l'acide bromo-, chloro-, dichloro-, trichloro-, trifluoro-acétique ; l'acide propionique ; l'acide butyrique ; l'acide α-, β-, χ-chlorobutyrique ; l'acide valérique ; l'acide 2-, 4-, 5- bromovalérique ; l'acide lactique ; l'acide salicylique ; l'acide acétylsalicylique ; et les mélanges de deux au moins de ceux-ci. De préférence, le monoacide organique est l'acide propionique.

Le monoacide selon l'invention peut, le cas échéant, être utilisé en mélange avec un acide minéral comme par exemple l'acide chlorhydrique.

La concentration en monoacide(s) organique(s) dans la solution est avantageusement comprise entre 0,1 et 5 M, de préférence entre 0,5 et 2 M, bornes incluses.

Au sens de l'invention, par solvant polaire, on entend un solvant possédant un moment dipolaire qui peut ou non posséder un ou plusieurs atomes d'hydrogène susceptibles de former des liaisons hydrogène. A ce titre on peut citer, par exemple l'eau, le méthanol, l'éthanol, l'acétonitrile (CH₃CN), le diméthylsulfoxyde (DMSO, (CH₃)₂SO), le tétrahydrofuranne(THF, C₄H₈O), etc.

Dans la solution mise en oeuvre à l'étape a), le solvant polaire est plus particulièrement choisi parmi l'eau, le méthanol, l'éthanol, le propanol, l'isopropanol, le n-butanol, l'éther éthylique, le THF, le DMF, le DMSO, et les mélanges de deux au moins de ceux-ci. De préférence, dans la solution mise en oeuvre à l'étape a), le solvant contient au moins 80% en poids d'eau. Encore plus préférentiellement, le solvant est l'eau.

Le rapport molaire entre le(s) précurseur(s) de Br₂ ou de Cl₂ et le(s) monoacide(s) organique(s) dans la solution à l'étape a), est compris entre 0,02 et 1, de préférence entre 0,05 et 0,2, bornes incluses.

Toujours dans l'étape a), la solution comprend également au moins un composé de formule MX dans laquelle M et X sont tels que définis précédemment. Ce composé peut améliorer la dissolution du Br₂ ou du Cl₂, et/ou la stabilité de la solution de gravure.

Selon un mode de réalisation préféré de l'invention, la solution de l'étape a) est une solution comprenant du KBrO₃ ou du KBrO, du KBr et de l'acide propionique dans l'eau.

Le substrat dont la couche de surface en CIGS est à graver, est immergé dans la solution de gravure. Cette immersion est réalisée de manière à ce que le substrat se trouve complètement immergé dans la solution de gravure.

Le substrat immergé dans ladite solution est ensuite soumis à un traitement thermique au cours duquel le Br₂ ou le Cl₂ généré, réagit sélectivement avec la couche de surface précitée.

Plus particulièrement, le traitement thermique dans l'étape b) est effectué à une température comprise entre 25 et 80°C, de préférence entre 25 et 60°C, bornes incluses.

La durée du traitement themique peut être comprise entre 1 seconde et 15 minutes, de préférence entre 30 secondes et 5 minutes, bornes incluses.

C'est, en effet, ce traitement thermique qui permet la gravure sélective par Br₂ ou Cl₂, généré *in situ.* Le Br₂ ou le Cl₂, ainsi généré attaquera alors la couche de surface en CIGS sans attaquer la couche métallique sous-jacente.

Selon la nature du précurseur utilisé à l'étape a), on génère du Br₂ ou du Cl₂. De préférence, on génère du Br₂.

D'une manière générale, la concentration en Br₂ ou en Cl₂ en solution, est comprise entre 0,001 et 1 mol/l, bornes incluses.

Dans l'étape b), afin d'homogénéiser la solution et d'obtenir ainsi une gravure plus uniforme, la solution peut être agitée, par exemple au moyen d'un agitateur magnétique. L'homme du métier saura choisir la vitesse d'agitation adaptée en fonction du volume à traiter et de la température.

Avec le procédé de l'invention, la vitesse de gravure de la couche de surface en CIGS est au moins 25 fois plus rapide que la vitesse de gravure de la couche métallique sous-jacente comprenant du molybdène. Dès lors, on peut contrôler la gravure de la couche de surface afin qu'à l'issue de l'étape b), la couche métallique sous-jacente reste intacte.

Selon un autre mode de réalisation du procédé de l'invention, le substrat et plus particulièrement la couche de surface en CIGS, est protégé, partiellement avec une résine photo-lithographique selon les procédés connus.

L'invention a également pour objet un procédé de réalisation de cellules en série dans un module photovoltaïque en couches minces comprenant au moins une couche de surface en CIGS, et une couche métallique sous-jacente comprenant du molybdène déposée sur un support, caractérisé en ce que l'on réalise des cellules en série dans ledit module en utilisant le procédé de gravure chimique sélective par voie humide selon l'invention.

L'invention a, en outre, pour objet un procédé pour créer des motifs de dimensions réduites, comme par exemple des interconnexions monolithiques, sur des dispositifs photovoltaïques en couches minces comprenant au moins une couche de surface en CIGS, et une couche métallique sous-jacente comprenant du molybdène déposée sur un support, caractérisé en ce que l'on crée des motifs de dimensions réduites, comme par exemple des interconnexions monolithiques, sur ledit dispositif photovoltaïque en couches minces en utilisant le procédé de gravure chimique sélective par voie humide selon l'invention. Les dimensions des motifs ainsi crées sont de l'ordre de l'épaisseur de la couche de CIGS.

D'autres avantages et caractéristiques de la présente invention pourront encore apparaître à la lecture des exemples ci-dessous donnés à titre illustratif et les figures annexées :

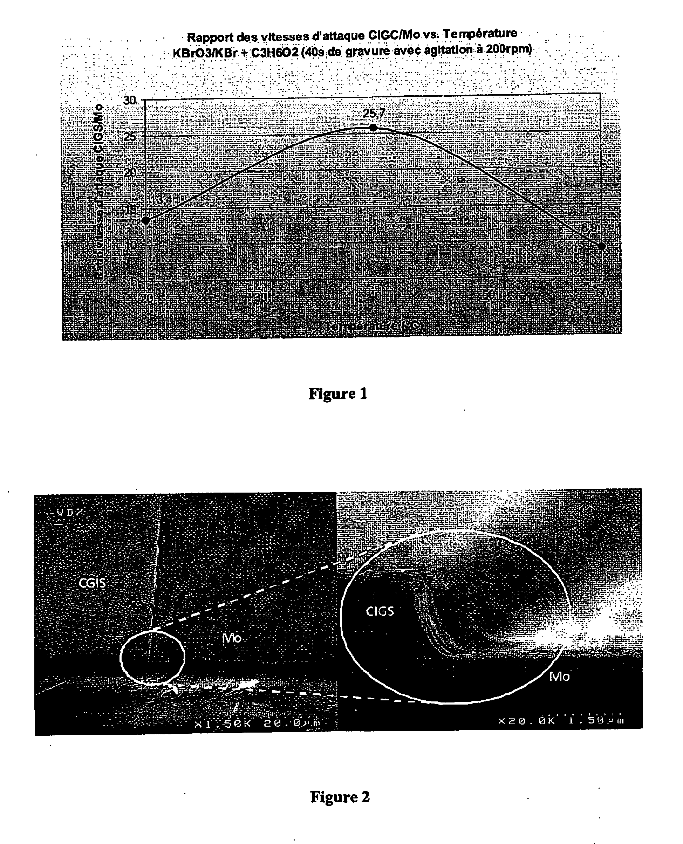

- la Figure 1 représente le rapport des vitesses d'attaque de couches de type CIGS/Mo, en fonction de la température. Les rapports de vitesse d'attaque ont été déterminés après 40 secondes de gravure à 20°C, 40°C et 60°C, avec une solution de gravure comprenant du KBrO₃/KBr et de l'acide propionique sous agitation à 200 tours/min ;
- la Figure 2 représente des photographies prises au microscope électronique à balayage d'un sillon gravé sur un substrat comprenant un support en verre sodo-calcique revêtu d'une couche de molybdène, elle-même revêtue d'une couche en CIGS. Cette gravure a été effectuée selon l'exemple 2, avec une solution bromée contenant de l'acide propionique (gravure pendant 180 secondes à 40°C, sous agitation à 200 tours/min.). L'image de droite, qui est un agrandissement d'un détail de l'image de gauche, montre que la couche de CIGS a bien été gravée jusqu'à la couche de molybdène mais sans que la couche sous-jacente de molybdène ne soit attaquée par la solution de gravure.

### EXEMPLES

### EXEMPLE 1 :

La solution de gravure comprend 400 ml d'une solution 0,9M d'acide propionique dans du KBrO₃/KBr (Bromide bromate Standard Solution ready-to-use 0,25M Br- (0,5N), commercialisé par la société Fluka sous la référence 35007).

Un échantillon (1) constitué d'un support en verre sodo-calcique recouvert d'une couche de molybdène déposée par PVD, elle-même recouverte d'une couche de 1,5 µm de CIGS déposée par co-évaporation sous vide, et un échantillon (2) constitué d'un support en verre sodo-calcique recouvert seulement d'une couche de 0,5 µm de molybdène déposé par PVD, sont immergés dans la solution de gravure.

Le mélange est ensuite porté jusqu'à une température de 60°C à l'intérieur d'un bécher double-paroi qui est à son tour thermo-régulé par un polystat. Afin d'homogénéiser le mélange et d'obtenir ainsi une gravure plus uniforme, la solution est agitée avec un agitateur magnétique à 200 tours/minute.

Les rapports des vitesses d'attaque des couches en CIGS et en Mo (CIGS/Mo) ont été analysés aux températures de 20°C, 40°C, 60°C, et pour une durée fixée à 40 secondes (voir Figure 1).

La Figure 1 montre que la vitesse de gravure est maximale après un traitement thermique à 40°C pendant 40 secondes, et que dans ces conditions, l'échantillon (1) qui est constitué d'un support en verre sodo-calcique recouvert d'une couche de molybdène, elle-même recouverte d'une couche de 1,5µm de CIGS, est gravé 25,7 fois plus rapidement que l'échantillon (2) qui est constitué d'un support en verre sodo-calcique recouvert d'une couche de 0.5µm de molybdène seulement.

### EXEMPLE 2 :

Un échantillon constitué d'un support en verre sodo-calcique recouvert d'une couche de molybdène, elle-même recouverte d'une couche de 1,5µm de CIGS, préparé selon le mode opératoire indiqué à l'exemple 1, est protégé partiellement avec de la résine photolithographique. L'échantillon est ensuite immergé dans 400 ml d'une solution 0,9M d'acide propionique dans du KBrO₃/KBr (Bromide bromate Standard Solution ready-to-use 0,25M Br- (0,5N), commercialisé par la société Fluka sous la référence 35007).

Le mélange est ensuite porté à une température de 40°C pendant 180 secondes à l'intérieur d'un bécher double-paroi qui est à son tour thermo-régulé par un polystat. Afin d'homogénéiser le mélange et d'obtenir ainsi une gravure plus uniforme, la solution est agitée avec un agitateur magnétique à 200 tours/minute.

Le résultat de cette gravure est visible dans la Figure 2.

L'image de droite, qui est un agrandissement d'un détail de l'image de gauche, montre que la couche de CIGS a bien été gravée mais que ni la couche sous-jacente de molybdène ni la résine photolithique n'est attaquée par la solution de gravure.

## Revendications

1. Procédé de gravure chimique sélective par voie humide d'un substrat en couches minces comprenant au moins une couche de surface en CIGS à graver, et une couche métallique sous-jacente comprenant du molybdène déposée sur un support, **caractérisé en ce qu'**il comprend les étapes suivantes :
a) immerger le substrat à graver dans une solution comprenant :
- au moins un précurseur de Br₂ ou de Cl₂,
- au moins un monoacide organique, et
- au moins un composé de formule MX dans laquelle
• M représente un métal alcalin choisi parmi le sodium, le potassium ;
• X représente un atome d'halogène choisi parmi le chlore, le brome ;
b) soumettre le substrat immergé dans la solution mise en oeuvre à l'étape a), à un traitement thermique permettant la réaction sélective de Br₂ ou de Cl₂ avec la couche de surface précitée.

2. Procédé selon la revendication 1, **caractérisé en ce que** la solution mise en oeuvre à l'étape a) comprend :
- au moins un précurseur de Br₂ ou de Cl₂ de formule (I) :
MXOₓ (I)
dans laquelle M et X ont les mêmes définitions que dans la revendication 1 et x est un nombre entier compris entre 1 et 3, bornes incluses ; et
- au moins un solvant polaire.

3. Procédé selon l'une des revendications 1 ou 2, **caractérisé en ce que** le monoacide organique satisfait aux conditions suivantes :
- 0,5≤pKa<5;
- 60 g/mole ≤ masse moléculaire ≤ 200 g/mole ;
- 20 g/l ≤ solubilité ≤ 1000 g/l.

4. Procédé selon l'une quelconque des revendications 1 à 3, **caractérisé en ce que** le monoacide organique est choisi parmi l'acide acétique ; l'acide bromo-, chloro-, dichloro-, trichloro-, trifluoro-acétique ; l'acide propionique ; l'acide butyrique ; l'acide α-, β-, χ-chlorobutyrique ; l'acide valérique ; l'acide 2-, 4-, 5-bromovalérique ; l'acide lactique ; l'acide salicylique ; l'acide acétylsalicylique ; et les mélanges de deux au moins de ceux-ci.

5. Procédé selon l'une quelconque des revendications 2 à 4, **caractérisé en ce que** dans la solution mise en oeuvre à l'étape a), le solvant polaire est choisi parmi l'eau, le méthanol, l'éthanol, le propanol, l'isopropanol, le n-butanol, l'éther éthylique, le THF, le DMF, le DMSO, et les mélanges de deux au moins de ceux-ci.

6. Procédé selon l'une quelconque des revendications 1 à 5, **caractérisé en ce que** la concentration en monoacide(s) organique(s) dans la solution est comprise entre 0,1 et 5 M, bornes incluses.

7. Procédé selon l'une quelconque des revendications 1 à 6, **caractérisé en ce que** dans la solution à l'étape a), le rapport molaire entre le(s) précurseur(s) de Br₂ ou de Cl₂ et le(s) monoacide(s) organique(s) est compris entre 0,02 et 1, bornes incluses.

8. Procédé selon l'une quelconque des revendications 1 à 7, **caractérisé en ce que** la solution de l'étape a) comprend du KBrO₃ ou KBrO, du KBr et de l'acide propionique dans l'eau.

9. Procédé selon l'une quelconque des revendications 1 à 8, **caractérisé en ce que** le traitement thermique dans l'étape b) est effectué à une température comprise entre 25 et 80°C, bornes incluses.

10. Procédé selon l'une quelconque des revendications 1 à 9, **caractérisé en ce que** le traitement thermique dans l'étape b) est effectué pendant une durée comprise entre 1 seconde et 15 minutes, bornes incluses.

11. Procédé selon l'une quelconque des revendications 1 à 10, **caractérisé en ce que** la concentration en Br₂ ou en Cl₂ générée en solution est comprise entre 0,001 et 1 mol/l, bornes incluses.

12. Procédé de réalisation de cellules en série dans un module photovoltaïque en couches minces comprenant au moins une couche de surface en CIGS, et une couche métallique sous-jacente comprenant du molybdène déposée sur un support, **caractérisé en ce que** l'on réalise des cellules en série dans ledit module en utilisant le procédé de gravure chimique sélective par voie humide selon l'une quelconque des revendications 1 à 11.

13. Procédé pour créer des motifs de dimensions réduites sur des dispositifs photovoltaïques en couches minces comprenant au moins une couche de surface en CIGS, et une couche métallique sous-jacente comprenant du molybdène déposée sur un support, **caractérisé en ce que** l'on crée des motifs de dimensions réduites sur ledit dispositif photovoltaïque en couches minces en utilisant le procédé de gravure chimique sélective par voie humide selon l'une quelconque des revendications 1 à 11.

## Patentansprüche

1. Verfahren zum selektiven chemischen Nassätzen eines Dünnschichtsubstrats, das mindestens eine zu ätzende CIGS-Oberflächenschicht umfasst und eine darunterliegende Metallschicht, die auf einem Träger abgeschiedenes Molybdän umfasst, **dadurch gekennzeichnet, dass** es die folgenden Schritte umfasst:
a) Eintauchen des zu ätzenden Substrats in eine Lösung, die umfasst:
- mindestens einen Vorläufer von Br₂ oder Cl₂,
- mindestens eine einbasige organische Säure und
- mindestens eine Verbindung der Formel MX, wobei
• M ein Alkalimetall, ausgewählt aus Natrium und Kalium, bedeutet;
• X ein Halogenatom, ausgewählt aus Chlor und Brom, bedeutet;
b) Wärmebehandlung des in die in Schritt a) verwendete Lösung eingetauchten Substrats, was die selektive Reaktion von Br₂ oder Cl₂ mit der oben genannten Oberflächenschicht erlaubt.

2. Verfahren nach Anspruch 1, **dadurch gekennzeichnet, dass** die in Schritt a) verwendete Lösung umfasst:
- mindestens einen Vorläufer von Br₂ oder Cl₂ der Formel (I):
MXOₓ (I)
wobei M und X die gleichen Bedeutung wie in Anspruch 1 haben und x eine ganze Zahl zwischen 1 und 3, einschließlich der Grenzwerte, ist; und
- mindestens ein polares Lösungsmittel.

3. Verfahren nach einem der Ansprüche 1 oder 2, **dadurch gekennzeichnet, dass** die einbasige organische Säure die folgenden Bedingungen erfüllt:
- 0,5 ≤ pKa < 5;
- 60 g/mol ≤ Molmasse ≤ 200 g/mol;
- 20 g/l ≤ Löslichkeit ≤ 1000 g/l.

4. Verfahren nach einem der Ansprüche 1 bis 3, **dadurch gekennzeichnet, dass** die einbasige organische Säure ausgewählt ist aus Essigsäure; Brom-, Chlor-, Dichlor-, Trichlor-, Trifluoressigsäure; Propionsäure; Buttersäure; α-, β-, X-Chlorbuttersäure; Valeriansäure; 2-, 4-, 5-Bromvaleriansäure; Milchsäure; Salicylsäure; Acetylsalicylsäure; und Mischungen aus mindestens zwei davon.

5. Verfahren nach einem der Ansprüche 2 bis 4, **dadurch gekennzeichnet, dass** das polare Lösungsmittel in der in Schritt a) verwendeten Lösung ausgewählt ist aus Wasser, Methanol, Ethanol, Propanol, Isopropanol, n-Butanol, Ethylether, THF, DMF, DMSO und Mischungen von mindestens zwei davon.

6. Verfahren nach einem der Ansprüche 1 bis 5, **dadurch gekennzeichnet, dass** die Konzentration der einbasigen organischen Säure(n) in der Lösung zwischen 0,1 und 5 M, einschließlich der Grenzwerte, liegt.

7. Verfahren nach einem der Ansprüche 1 bis 6, **dadurch gekennzeichnet, dass** das Molverhältnis zwischen dem/den Vorläufer(n) von Br₂ oder Cl₂ und der/den einbasigen organischen Säure(n) in der Lösung in Schritt a) zwischen 0,02 und 1, einschließlich der Grenzwerte, liegt.

8. Verfahren nach einem der Ansprüche 1 bis 7, **dadurch gekennzeichnet, dass** die Lösung in Schritt a) KBrO₃ oder KBrO, KBr und Propionsäure in Wasser umfasst.

9. Verfahren nach einem der Ansprüche 1 bis 8, **dadurch gekennzeichnet, dass** die Wärmebehandlung in Schritt b) bei einer Temperatur zwischen 25 und 80 °C, einschließlich der Grenzwerte, durchgeführt wird.

10. Verfahren nach einem der Ansprüche 1 bis 9, **dadurch gekennzeichnet, dass** die Wärmebehandlung in Schritt b) über eine Dauer zwischen 1 Sekunde und 15 Minuten, einschließlich der Grenzwerte, durchgeführt wird.

11. Verfahren nach einem der Ansprüche 1 bis 10, dadurch gekenntzeichnet, dass die in Lösung gebildete Konzentration von Br₂ oder Cl₂ zwischen 0,001 und 1 mol/l, einschließlich der Grenzwerte, liegt.

12. Verfahren zur Herstellung von Zellen in Reihe in einem Dünnschicht-Photovoltaikmodul, das mindestens eine CIGS-Oberflächenschicht umfasst und eine darunter liegende Metallschicht, die auf einem Träger abgeschiedenes Molybdän umfasst, **dadurch gekennzeichnet, dass** Zellen in dem Modul in Reihe unter Verwendung des selektiven chemischen Nassätzverfahrens nach einem der Ansprüche 1 bis 11 hergestellt werden.

13. Verfahren zur Erzeugung von Mustern geringer Dimensionen auf photovoltaischen Dünnschichtvorrichtungen, die mindestens eine CIGS-Oberflächenschicht umfassen und eine darunterliegende Metallschicht, die auf einem Träger abgeschiedenes Molybdän umfasst, **dadurch gekennzeichnet, dass** auf der photovoltaischen Dünnschichtvorrichtung Muster geringer Dimensionen unter Verwendung des selektiven chemischen Nassätzverfahrens nach einem der Ansprüche 1 bis 11 erzeugt werden.

## Claims

1. Process for the selective wet chemical etching of a thin-layer substrate comprising at least a CIGS surface layer for etching and an underlying metal layer comprising molybdenum deposited on a support, **characterised in that** it comprises the following steps:
a) immersing the substrate to be etched in a solution comprising:
- at least one precursor of Br₂ or of Cl₂,
- at least one organic monoacid, and
- at least one compound of the formula MX wherein
• M represents an alkali metal chosen from sodium, potassium;
• X represents a halogen atom chosen from chlorine, bromine;
b) subjecting the substrate immersed in the solution employed in step a) to heat treatment permitting the selective reaction of Br₂ or of Cl₂ with the above-mentioned surface layer.

2. Process according to claim 1, **characterised in that** the solution employed in step a) comprises:
- at least one precursor of Br₂ or of Cl₂ of formula (I):
MXOₓ (I)
wherein M and X have the same definitions as in claim 1 and x is an integer from 1 to 3 inclusive; and
- at least one polar solvent.

3. Process according to either claim 1 or claim 2, **characterised in that** the organic monoacid satisfies the following conditions:
- 0.5 ≤ pKa < 5;
- 60 g/mol ≤ molecular mass ≤ 200 g/mol;
- 20 g/l ≤ solubility ≤ 1000 g/l,

4. Process according to any one of claims 1 to 3, **characterised in that** the organic monoacid is chosen from acetic acid; bromo-, chloro-, dichloro-, trichloro-, trifluoroacetic acid; propionic acid; butyric acid; α-, β-, χ-chlorobutyric acid; valeric acid; 2-, 4-, 5-bromovaleric acid; lactic acid; salicylic acid; acetylsalicylic acid; and mixtures of at least two thereof.

5. Process according to any one of claims 2 to 4, **characterised in that**, in the solution employed in step a), the polar solvent is chosen from water, methanol, ethanol, propanol, isopropanol, n-butanol, ethyl ether, THF, DMF, DMSO, and mixtures of at least two thereof.

6. Process according to any one of claims 1 to 5, **characterised in that** the concentration of organic monoacid(s) in the solution is from 0.1 to 5 M inclusive.

7. Process according to any one of claims 1 to 6, **characterised in that**, in the solution in step a), the molar ratio between the precursor(s) of Br₂ or of Cl₂ and the organic monoacid(s) is from 0.02 to 1 inclusive.

8. Process according to any one of claims 1 to 7, **characterised in that** the solution of step a) comprises KBrO₃ or KBrO, KBr and propionic acid in water.

9. Process according to any one of claims 1 to 8, **characterised in that** the heat treatment in step b) is carried out at a temperature of from 25 to 80°C inclusive.

10. Process according to any one of claims 1 to 9, **characterised in that** the heat treatment in step b) is carried out for a period of from 1 second to 15 minutes inclusive.

11. Process according to any one of claims 1 to 10, **characterised in that** the concentration of Br₂ or of Cl₂ generated in solution is from 0.001 to 1 mol/l inclusive.

12. Process for producing cells in series in a thin-film photovoltaic module comprising at least a CIGS surface layer and an underlying metal layer comprising molybdenum deposited on a support, **characterised in that** cells are produced in series in said module using the selective wet chemical etching process according to any one of claims 1 to 11.

13. Process for creating patterns of small size on thin-layer photovoltaic devices comprising at least a CIGS surface layer and an underlying metal layer comprising molybdenum deposited on a support, **characterised in that** patterns of small size are created on said thin-layer photovoltaic device using the selective wet chemical etching process according to any one of claims 1 to 11.
